# EUROPEAN PATENT APPLICATION

(11) **EP 4 628 988 A1**
(43) Date of publication of application: **08.10.2025**
(21) Application number: 24168588.2
(22) Date of filing: 04.04.2024
(51) Int. Cl.: G03F 1/36, G03F 7/00

(54) **METHODS AND CORRESPONDING SYSTEMS FOR THE PREDICTION OF DEFECTS IN WAFERS AND FOR OFFLINE WAFER-LESS PROCESS WINDOW QUALIFICATION**

(71) Applicant: Carl Zeiss SMT GmbH, 73447 Oberkochen (DE)
(72) Inventor: SARASWATULA, JAGDISH, 73447 Oberkochen (DE); SEIDEL, DIRK, 07745 Jena (DE)
(74) Representative: Pfiz/Gauss Patentanwälte PartmbB

(57) **Abstract**

The invention relates to a method (30) for inspecting a photolithography mask (76) to predict defects (28) in wafers comprising: providing a model (10) of the photolithography mask (76) comprising one or more target features (14) and one or more sub-resolution assist features (22); identifying one or more critical locations (24) in the model (10) of the photolithography mask (76) by verifying a predefined constraint concerning the target features (14) and the sub-resolution assist features (22); acquiring an aerial image (44) of the photolithography mask (76) (24) using an aerial image measurement system (74) and a model of a photolithography system; and predicting defects (28) in wafers by comparing the one or more identified critical locations (24) in the aerial image (44) to one or more corresponding locations in a reference image (46).

## Description

### Field of the Invention

The invention relates to systems and methods for quality assurance of photolithography masks, more specifically to a method, and corresponding systems for the inspection of photolithography masks to predict defects, in particular sub-resolution assist feature related defects, in wafers. The method, computer-readable medium, computer program product and systems can be utilized for quantitative metrology, defect prediction, photolithography mask improvement or for process control, process monitoring or process improvement, in particular for process window qualification, without requiring the actual printing of a wafer.

### Background of the Invention

A wafer made of a thin slice of silicon serves as the substrate for microelectronic devices containing semiconductor structures built in and upon the wafer. The semiconductor structures are constructed layer by layer using repeated processing steps that involve repeated chemical, mechanical, thermal and optical processes. Dimensions, shapes and placements of the semiconductor structures and patterns are subject to several influences. One of the most crucial steps is the photolithography process.

Photolithography is a process used to produce patterns on the substrate. The patterns to be printed on the surface of the substrate are usually generated by computer-aided-design (CAD). From the design, for each layer a photolithography mask is generated, which contains a magnified image of the computer-generated pattern to be etched into the substrate. During the printing process an illuminated image projected from the photolithography mask is focused onto a photoresist thin film formed on the substrate. A semiconductor chip powering mobile phones or tablets comprises, for example, approximately between 80 and 120 patterned layers. In the past, when photolithography required less precision, the circuit layout equaled the mask pattern which equaled the wafer pattern.

Due to the growing integration density in the semiconductor industry, photolithography masks have to image increasingly smaller structures onto wafers. The aspect ratio and the number of layers of integrated circuits constantly increases and the structures are growing into 3^{rd} (vertical) dimension. The current height of the memory stacks is exceeding a dozen of microns. In contrast, the feature size is becoming smaller. The minimum feature size or critical dimension is below 10nm, for example 7nm or 5nm, and is approaching feature sizes below 3nm in near future. While the complexity and dimensions of the semiconductor structures are growing into the 3^{rd} dimension, the lateral dimensions of integrated semiconductor structures are becoming smaller. Producing the small structure dimensions imaged onto the wafer requires photolithographic masks or templates for nanoimprint photolithography with ever smaller structures or pattern elements. The production process of photolithographic masks and templates for nanoimprint photolithography is, therefore, becoming increasingly more complex and, as a result, more time-consuming and ultimately also more expensive. With the advent of EUV photolithography scanners, the nature of masks changed from transmission based to reflection-based patterning.

Today, the minimum feature size on the mask has reached sub-wavelength dimensions. Consequently, the so-called optical proximity effect caused by non-uniformity of energy intensity due to optical diffraction during the exposure process occurs. These deviations depend on the characteristics of the patterns as well as on a variety of process conditions. The optical proximity effect due to variations in focus and exposure of the photolithography process leads to parts of the design layout resulting in hot spots in the form of bridging, necking, line-end shortening, etc. As a result, images formed on the substrate do not faithfully reproduce the patterns on the photolithography mask and deviate from their ideal dimensions and shape as represented by the design computer images. These deviations can significantly affect the performance of the semiconductor device, thereby reducing the production yield.

In order to reduce pattern deformation caused by the optical proximity effect, compensation schemes have been applied to CAD files of photolithography masks such as optical proximity correction (OPC).

OPC is the process of correcting the layout of target patterns to be transferred onto a wafer using knowledge of the optical proximity effect. Current OPC techniques involve a computer simulation that takes the target pattern as initial dataset and modifies it to arrive at a corrected pattern, which compensates for the optical proximity effect. A photolithography mask can then be manufactured in accordance with the corrected pattern.

A known OPC technique for modifying a target pattern comprising target features, i.e., features to be printed on the wafer, is to add sub-resolution assist features (SRAFs) to the target pattern. These features are not intended for printing. They are placed close to the target features of the target pattern to improve their printability. SRAFs may be provided in the form of scattering bars. Since these additional features are sub-photolithographic, they will not be transferred to the wafer during printing.

The placement of SRAFs is commonly determined in a rule-based manner, where a set of SRAF design rules is used to generate SRAF structures based on the layout of the target features of the target pattern in the photolithography mask. Yet, the rules are based on a model that cannot account for all possible 2D or 3D pattern combinations. If, for example, SRAFs are too close to target features or to each other, errors can occur on the wafer. In addition, similar design configurations are not necessarily printed in a uniform way due to proximity effects.

The placement of SRAFs can, thus, lead to defects in the wafer. For example, there are defects due to the actual printing of SRAFs on the wafer. Furthermore, adjacent structures can be bridged due to an incorrect placement of SRAFs. Also, printed island-like SRAFs, which are not dissolved during etching, can lift off during chemical mechanical planarization (CMP) and deposit on critical areas of the wafer, short-circuiting and damaging the circuitry.

Such SRAF related defects in wafers resulting from SRAFs, e.g., due to their location or size, are very hard to detect. On the one hand, the CAD model of the photolithography mask contains target features and SRAFs, which look correct. On the other hand, the printed wafer contains defects which often look like regular structures. Thus, SRAF related defects are neither obvious from an analysis of the CAD model of the photolithography mask nor are they obvious from an analysis of the printed wafer.

Apart from ensuring the printability of the target design, SRAFs are also crucial to the qualification of the process window of the manufacturing process parameters to prevent systematic defects. During process window qualification, in each iteration a number of process parameter values, e.g., exposure time, focus variation, etc., is selected. By analyzing the defects on the wafer printed according to the selected process parameter values, the best manufacturing process parameters can be selected, and a window or range can be established for each process parameter, from which the respective process parameter value can be selected. The placement of SRAFs could lead to a narrowing of the process window, thus yielding defects during manufacturing of semiconductor devices. The placement of the SRAFs is, thus, not only important for the printability of the target pattern but also for the process window qualification of the manufacturing process.

Methods for anomaly detection and process window qualification are, for example, disclosed in US 6,902,855 B2 or US 8,703,405 B2. However, these methods require the actual printing of a wafer for verifying a photolithography mask design and for process window qualification, which requires a lot of resources and time of the semiconductor fabrication facilities (fabs).

It is, therefore, an objective of the invention to predict defects, in particular SRAF related defects, in wafers in order to prevent defects during printing of the wafers. Another objective of the invention is to provide a photolithography mask inspection method for the prediction of defects, in particular of SRAF related defects, in wafers without requiring an actual printing of the wafer. It is another objective of the invention to provide a wafer-less method for process window qualification. It is another objective of the invention to provide a photolithography mask inspection method for the prediction of defects, in particular SRAF related defects, in wafers, with improved accuracy. Another objective of the invention is to obtain an efficient defect prediction or process window qualification method of reduced runtime. Another objective is to obtain a defect prediction method which can be specifically adapted to certain defect types. Another objective is to increase the throughput of the defect prediction methods and of photolithography mask inspection systems. Another objective of the invention is to reduce the effort for the applicant required to predict defects in wafers.

The objectives are achieved by the invention specified in the independent claims. Advantageous embodiments and further developments of the invention are specified in the dependent claims.

### Summary of the invention

Embodiments of the invention concern methods and systems for inspecting a photolithography mask to predict defects in wafers, in particular sub-resolution assist feature related defects.

A first embodiment of the invention involves a method for inspecting a photolithography mask to predict defects in wafers, the method comprising: providing a model of the photolithography mask comprising one or more target features and one or more sub-resolution assist features, the photolithography mask being configured for printing of the one or more target features onto a wafer in a printing process using a photolithography system; identifying one or more critical locations in the model of the photolithography mask by verifying a predefined constraint concerning the target features and the sub-resolution assist features; acquiring an aerial image of the photolithography mask comprising one or more identified critical locations using an aerial image measurement system and a model of the photolithography system; and predicting defects in wafers by comparing the one or more identified critical locations in the aerial image to one or more corresponding locations in a reference image.

According to an example of the first embodiment of the invention, the predicted defects comprise SRAF related defects. SRAF related defects refer to defects resulting from SRAFs, e.g., due to their location or size. This is beneficial, as defects due to SRAFs are neither visible from inspecting the photolithography mask nor from inspecting the printed wafer alone.

An aerial image is the radiation intensity distribution at substrate level. By acquiring the aerial image of the photolithography mask, the patterns that will be printed on the wafer can be inspected for defects without actually printing a wafer. In this way, defects, in particular SRAF related defects, can be predicted. In addition, wafer-less process window qualification is possible. By identifying one or more critical locations in the model of the photolithography mask and limiting the defect prediction to these critical locations, the runtime of the method is reduced and, thus, the efficiency of the method improved.

The term "defect" refers to a localized deviation of an integrated circuit pattern on a wafer from an a priori defined norm of the integrated circuit pattern. A defect of an integrated circuit pattern, e.g., of a semiconductor structure, can result in malfunctioning of an associated semiconductor device. Depending on the detected defect, for example, the photolithography process can be improved, or photolithography masks or wafers can be repaired or discarded. The norm of the structure or pattern can be defined by one or more corresponding reference wafers or reference datasets, e.g., by design datasets, simulated datasets or acquired defect-free datasets.

A target feature refers to a structure of a target pattern on a photolithography mask that is to be printed on a wafer. A sub-resolution assist feature (SRAF) refers to an additional structure on a photolithography mask that is not intended for printing. It is usually placed close to a target feature of the target pattern to improve its printability, e.g., to prevent round edges, line thinning and line shortening due to the optical proximity effect. SRAFs may be provided in the form of scattering bars. Since these additional features are sub-photolithographic, they will not be transferred to the wafer during printing. However, they can still cause defects on a wafer, e.g., if two SRAFs are placed close to each other.

A model of a photolithography mask refers to a representation of the target features and the SRAF features of a photolithography mask, preferably in a computer readable form, e.g., a CAD model, an image or a textual description.

A photolithography system refers to a system that prints a pattern onto a wafer using a photolithography mask. The structures of the pattern on the photolithography mask are imaged onto a light-sensitive resist deposited on a substrate. A photolithography system can refer to an EUV photolithography system that uses reflection-based photolithography masks or to a photolithography system that uses transmission-based photolithography masks. A model of a photolithography system comprises parameters that can be selected, e.g., a light configuration or mask parameters. It can be used to simulate the photolithography process in the photolithography system.

An aerial image measurement system refers to a system that generates an aerial image from a photolithography mask. It is used for the prediction of wafer printability for critical structures including, e.g., dense target patterns and defects. It can use a model of a photolithography system to simulate the photolithography process when printing to a wafer using the photolithography system.

The photolithography mask may have an aspect ratio of between 1:1 and 1:4, preferably between 1:1 and 1:2, most preferably of 1:1 or 1:2. The photolithography mask may have a nearly rectangular shape. The photolithography mask may be preferably 5 to 7 inch long and wide, most preferably 6 inch long and wide. Alternatively, the photolithography mask may be 5 to 7 inch long and 10 to 14 inch wide, preferably 6 inch long and 12 inch wide.

The method can, optionally, comprise using the predicted defects to modify the model of the photolithography mask, in particular the SRAFs of the model of the photolithography mask, e.g., the size and/or location of target features and/or SRAFs can be modified, or target features and/or SRAFs can be removed or added to the model of the photolithography mask. In this way, the model of the photolithography mask can be improved and defects during printing can be prevented.

The method can, optionally, comprise using the predicted defects to repair the photolithography mask, e.g., by sending the photolithography mask to a repair shop. In this way, the photolithography mask can be improved and defects during printing can be prevented.

The method can, optionally, use the predicted defects to modify parameters of the manufacturing process, e.g., parameters of the lithography process, parameters of the etching process or parameters of the CMP process.

According to an example of the first embodiment of the invention, the model of the photolithography mask comprises a CAD model comprising the one or more target features and the one or more sub-resolution assist features.

According to an example of the first embodiment of the invention, the predefined constraint comprises a space constraint between target features and/or SRAFs.

For example, the space constraint can comprise a minimum distance between target features and/or sub-resolution assist features, preferably a minimum distance below 60 nm, more preferably below 50 nm, most preferably below 40 nm. In this way, target features and SRAFs which are very close to each other and, thus, are likely to cause errors during printing of the wafer form critical locations, which are further inspected for defects based on the aerial image. In this way, defects during printing of the wafers can be prevented.

For example, the predefined constraint can comprise an area constraint defining a minimum area of target features and/or SRAFs. In this way, target features and/or SRAFs which are small and, thus, are likely to cause errors during printing of the wafer form critical locations, which are further inspected for defects based on the aerial image. In this way, defects during printing of the wafers can be prevented.

For example, the predefined constraint can comprise a size constraint defining a minimum size of one or more dimensions of target features and/or SRAFs. In this way, target features and/or SRAFs which are very thin in one or more dimensions and, thus, are likely to cause errors during printing of the wafer form critical locations, which are further inspected for defects based on the aerial image. In this way, defects during printing of the wafers can be prevented.

For example, the predefined constraint can comprise predefined shapes of target features and/or an SRAFs. In this way, target features and/or SRAFs of a specific type, e.g., L-shaped features, known to cause errors during printing of the wafer form critical locations. The critical locations are further inspected for defects based on the aerial image. In this way, defects during printing of the wafers can be prevented.

For example, the predefined constraint can comprise a predefined pattern of target features and/or SRAFs. In this way, patterns of target features and/or SRAFs, e.g., logical patterns, which are likely to cause errors during printing of the wafer form critical locations, which are further inspected for defects based on the aerial image. In this way, defects during printing of the wafers can be prevented.

For example, the predefined constraint can comprise a predefined location of target features and/or sub-resolution assist features, e.g., an alignment feature used to align the photolithography mask to a wafer, overlays or overlapping target features. In this way, target features and/or SRAFs in specific locations, which are likely to cause errors during printing of the wafer form critical locations, which are further inspected for defects based on the aerial image. In this way, defects during printing of the wafers can be prevented.

According to an example of the first embodiment of the invention, each target feature and each SRAF is associated with a metric value and the predefined constraint is associated with a limit value, and a predefined number of critical locations is selected from the one or more identified critical locations according to the distance of the metric value of the corresponding target feature or SRAF to the limit value. In this way, the critical locations can be sorted according to the deviation of the metric value of the associated target feature or SRAF from the limit value of the predefined constraint. Then a predefined number, e.g., 400, of the most critical locations, i.e., the critical locations comprising target features or SRAFs, whose metric value deviates most from the limit value, can be selected for further inspection. In this way, the inspection of the defects is limited to the most critical locations, where defects are most likely. Thus, the runtime of the method is reduced, and the efficiency is improved leading to a higher throughput of the method.

According to an example of the first embodiment of the invention, the reference image comprises a software simulation of an aerial image of the model of the photolithography mask comprising one or more identified critical locations. In this way, the accuracy of the predicted defects is improved.

According to an example of the first embodiment of the invention, the reference image comprises an aerial image of a photolithography mask obtained from a database, the aerial image comprising target features substantially identical to the target features in the one or more identified critical locations of the photolithography mask. In this way, the accuracy of the predicted defects is improved.

According to an example of the first embodiment of the invention, the reference image comprises an aerial image of a second photolithography mask comprising target features substantially identical to the target features in the one or more identified critical locations of the photolithography mask. In this way, the accuracy of the predicted defects is improved. At the same time, the effort for the applicant is reduced.

According to an example of the first embodiment of the invention, the reference image comprises an acquired aerial image or a simulated aerial image of a different portion of the photolithography mask comprising target features substantially identical to the target features in the one or more identified critical locations of the photolithography mask. In this way, the accuracy of the predicted defects is improved. At the same time, the effort for the applicant is reduced.

According to an example of the first embodiment of the invention, the reference image is generated by a machine learning model that maps the aerial image to a substantially defect-free aerial image. The machine learning model can, e.g., comprise an autoencoder. In this way, the accuracy of the predicted defects is improved. At the same time, the effort for the applicant is even further reduced.

According to an example of the first embodiment of the invention, comparing the aerial image to the reference image comprises the computation of at least one distance measure, in particular at least one distance metric. In this way, the accuracy of the predicted defects is improved.

According to an example of the first embodiment of the invention, comparing the aerial image to the reference image comprises the application of a machine learning model. In this way, the accuracy of the predicted defects is improved.

In an example, the photolithography mask is associated with a layer of a semiconductor design, and the aerial image is acquired using aerial image intensity models of layers below the layer associated with the photolithography mask that are provided by the aerial image measurement system. By considering further layers below the actual layer during the acquisition of the aerial image, the accuracy of the acquired aerial image and, thus, the accuracy of the predicted defects is improved.

According to an example of the first embodiment of the invention, the photolithography mask is associated with a layer of a semiconductor design, and the aerial image simulates back-scattering of light from printed layers below the layer associated with the photolithography mask. By considering light reflected from layers below, the aerial image and, thus, the accuracy of the predicted defects is improved.

A method for wafer-less process window qualification for a photolithography mask and a photolithography system according to a second embodiment of the invention comprises iterating the following steps: for at least one photolithography process parameter of the photolithography system selecting a photolithography process parameter value from a predefined range of photolithography process parameter values; inspecting the photolithography mask to predict defects in wafers using a method for inspecting a photolithography mask to predict defects in wafers according to any one of the methods described above, wherein the aerial image of the photolithography mask is generated using the aerial image measurement system and a model of the photolithography system comprising the at least one selected photolithography process parameter value. After the final iteration, a process window for the at least one photolithography process parameter is provided by analyzing the predicted defects for different photolithography process parameter values. At least two iterations are carried out, preferably more.

In this way, wafer-less process window qualification is made possible. As no printing of wafers is required, the process window qualification process can be carried out offline, saving the fabs a lot of time, tools and resources.

The wafer-less process window qualification method according to the second embodiment of the invention, has several advantages: firstly, the defect prediction is more accurate, as the photolithography mask itself is used for defect prediction instead of only a model of the photolithography mask. Secondly, the process window is not influenced by nuisances, i.e., deviations of the printed wafer from the norm resulting from the printing process, which do not affect the functioning of the semiconductor device. Thirdly, the back-scattering effect is taken into account during process window qualification. Fourthly, stochastic effects of the scanner do not influence the process window qualification.

The wafer-less process window qualification can be a substitute for wafer-based process window qualification, or it can be used as a reference process for subsequent processes.

A computer-readable medium according to a third embodiment of the invention has stored thereon a computer program executable by a computing device, the computer program comprising code for executing any one of the methods for inspecting a photolithography mask to predict defects in wafers or for wafer-less process window qualification described above.

A computer program product according to a fourth embodiment of the invention comprises instructions which, when the program is executed by a computer, cause the computer to carry out any of the methods for inspecting a photolithography mask to predict defects in wafers or for wafer-less process window qualification described above.

A photolithography mask inspection system for the prediction of defects according to the fifth embodiment of the invention comprises an aerial image measurement system for acquiring an aerial image of the photolithography mask and a data analysis device comprising at least one memory and at least one processor configured to perform the steps of a method according to any one of the methods for inspecting a photolithography mask to predict defects described above.

A wafer-less process window qualification system according to a sixth embodiment of the invention comprises an aerial image measurement system for acquiring an aerial image of the photolithography mask and a data analysis device comprising at least one memory and at least one processor configured to perform the steps of a method for wafer-less process window qualification described above.

The invention described by examples and embodiments is not limited to the embodiments and examples but can be implemented by those skilled in the art by various combinations or modifications thereof.

### Brief Description of the Drawings

- Fig. 1a: shows a target pattern comprising target features within a model of a photolithography mask;
- Fig. 1b: shows the result of printing the target pattern in Fig. 1a to a wafer;
- Fig. 1c: illustrates an example of an OPC technique comprising the placement of sub-resolution assist features close to the target features yielding a corrected pattern;
- Fig. 1d: shows the result of printing the corrected pattern in Fig. 1c to a wafer, the printed corrected pattern comprising an SRAF related defect in the form of a bridge defect;
- Fig. 2: shows a flowchart of a method for inspecting a photolithography mask to predict defects, in particular sub-resolution assist feature related defects, in wafers according to a first embodiment of the invention;
- Fig. 3: illustrates the prediction of defects based on a comparison of an aerial image of the photolithography mask to a reference image;
- Fig. 4: illustrates the simulation of back-scattering during aerial image generation;
- Fig. 5: shows a flowchart of a method for wafer-less process window qualification for a photolithography mask and a photolithography system according to a second embodiment of the invention;
- Fig. 6: illustrates a photolithography mask inspection system for the prediction of defects according to a fifth embodiment of the invention; and
- Fig. 7: illustrates a wafer-less process window qualification system according to a sixth embodiment of the invention.

### Detailed Description

In the following, advantageous exemplary embodiments of the invention are described and schematically shown in the figures. Throughout the figures and the description, same reference numbers are used to describe same features or components. Dashed lines indicate optional elements.

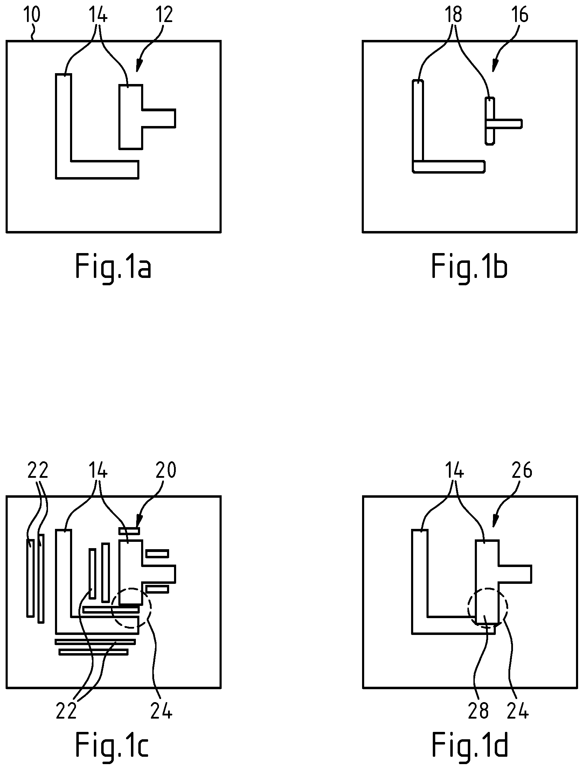

Fig. 1a shows a target pattern 12 comprising target features 14 within a model 10 of a photolithography mask 76. Due to the sub-wavelength size of the target features 14, optical proximity effects occur during the photolithography process. Optical proximity effects are caused by the non-uniformity of energy intensity due to optical diffraction during the exposure process. As a result, images formed on the wafer do not fully reproduce the target pattern12, since they deviate from their ideal dimensions and shape indicated by the model 10 of the photolithography mask 76. Fig. 1b shows the result of printing the target pattern 12 in Fig. 1a to a wafer. The printed pattern 16 comprises printed features 18, which deviate from the target features 14 due to optical proximity effects leading to, e.g., rounded edges, line thinning and line shortening. These deviations can significantly affect the performance of the semiconductor device. To compensate for these effects, optical proximity correction (OPC) techniques are applied to the model 10 of the photolithography mask 76. Fig. 1c illustrates an example of an OPC technique comprising the placement of sub-resolution assist features (SRAFs) 22 close to the target features 14 yielding a corrected pattern 20. SRAFs 22 may be provided in the form of scattering bars as shown in Fig. 1c. Since these additional features are sub-photolithographic, they will not be transferred to the wafer during printing. However, the placement of SRAFs 22 is difficult as there are infinitely many target feature combinations, and the SRAF models usually used for SRAF placement cannot account for all of these combinations. Therefore, defects 28 can occur on the wafer. For example, if SRAFs 22 are too close to a target feature 14 or to another SRAF 22, a defect 28 can occur on the wafer. Such defects 28 are SRAF related defects since they result from the placement of SRAFs. Fig. 1d shows the result of printing the corrected pattern 20 in Fig. 1c to a wafer, the printed corrected pattern 26 comprising an SRAF related defect 28 in the form of a bridge defect. In addition, the placement of SRAFs 22 influences the process window of the parameters of the manufacturing process. Hence, the placement of SRAFs 22 can be detrimental to the process window qualification and cause defects 28 in the wafer during the subsequent wafer manufacturing process. However, such SRAF related defects 28 are neither visible in the model 10 of the photolithography mask 76 nor can they be detected solely from an analysis of the wafer.

Process window qualification is commonly done by printing a number of wafers under different focus and exposure conditions and determining a window for each of these parameters within which the printing result is acceptable. However, this process is time consuming and occupies important resources of the fabs.

The novel methods and systems described herein solve these problems by acquiring an aerial image 44 of the photolithography mask 76. The generation of the aerial image 44 comprises separating target features 14 from SRAFs 22 based on optical intensity distributions in the aerial image 44 and excluding the SRAFs 22 from the aerial image 44. Based on the aerial image 44 defects 28 in the wafer can be predicted without actually printing the wafer. This information can be used for the prediction of defects 28, in particular SRAF related defects, as well as for wafer-less process window qualification. In order to obtain an efficient defect prediction method, critical locations 24 are identified in the model 10 of the photolithography mask 76, and only these critical locations 24 are further inspected for potential defects 28.

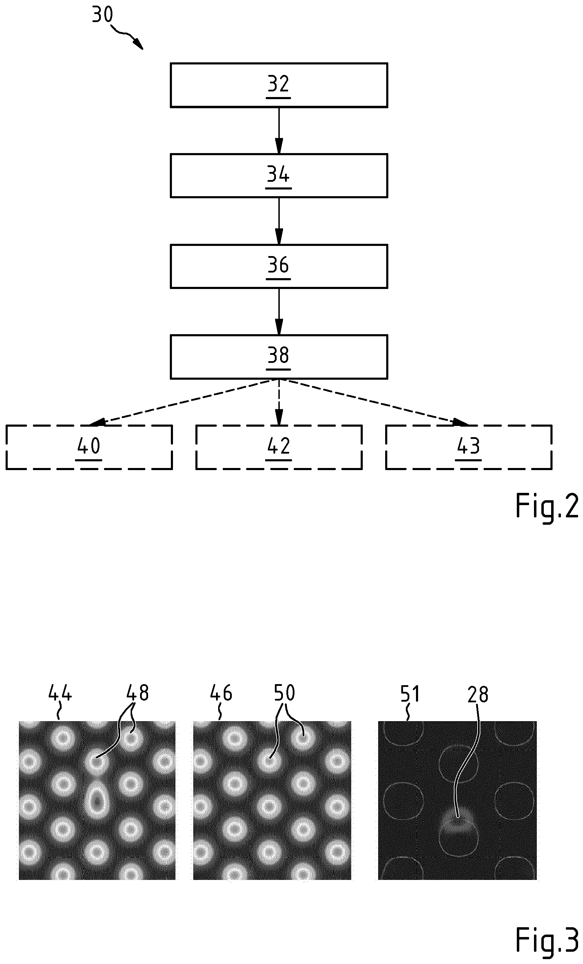

Fig. 2 shows a flowchart of a method 30 for inspecting a photolithography mask 76 to predict defects 28, in particular SRAF related defects, in wafers, according to a first embodiment of the invention, the method comprising: in a model providing step 32, providing a model 10 of the photolithography mask 76 comprising one or more target features 14 and one or more SRAFs 22, the photolithography mask 76 being configured for printing of the one or more target features 14 onto a wafer in a printing process using a photolithography system; identifying one or more critical locations 24 in the model 10 of the photolithography mask 76 by verifying a predefined constraint concerning the target features 14 and the SRAFs 22 in a critical location identification step 34; acquiring an aerial image 44 of the photolithography mask 76 comprising one or more identified critical locations 24 using an aerial image measurement system 74 and a model of the photolithography system tin an aerial image acquisition step 36; and predicting defects 28 in wafers by comparing the one or more identified critical locations 24 in the aerial image 44 to one or more corresponding locations in a reference image 46 in a defect prediction step 38.

The predicted defects 28 can, optionally, be used in different ways, e.g., for modification of the model 10 of the photolithography mask 76 in a model modification step 40, for photolithography mask repair in a repair step 42 or for process-based mitigation in a process step 43.

In an example, the method, optionally comprises using the predicted defects 28 to modify the model 10 of the photolithography mask 76, in particular the one or more SRAFs 22 of the model 10 of the photolithography mask 76, in a model modification step 40. For example, the location and/or size of the target features 14 and the one or more SRAFs 22 can be modified, or target features 14 and SRAFs 22 can be removed from the model 10 of the photolithography mask 76, or target features 14 and SRAFs 22 can be added to the model 10 of the photolithography mask 76.

In an example, the method optionally comprises using the predicted defects 28 to repair the photolithography mask 76 in a repair step 42. To this end, the photolithography mask 76 is sent to a photolithography mask repair system.

In an example, the method optionally comprises a process-based mitigation of the predicted defects 28 in a process mitigation step 43. During the process mitigation step 43 the predicted defects 28 are used to modify parameters of the manufacturing process, e.g., parameters of the lithography, the etching or the CMP process.

Based on the predefined constraint, critical locations 24 can be selected from the model 10 of the photolithography mask 76, and the prediction of defects 28 can be limited to these critical locations 24. In this way, the runtime of the defect prediction method can be reduced, since only the critical locations 24 are analyzed for defects. In addition, the defect analysis can be limited to specific defect types, e.g., bridge defects or overlay defects.

In an example of the first embodiment of the invention, the model 10 of the photolithography mask 76 comprises a CAD model comprising the one or more target features 14 and the one or more SRAFs 22. The model 10 of the photolithography mask 76 can be loaded from a database 86.

According to an example of the first embodiment of the invention, the predefined constraint comprises a space constraint between target features 14 and/or SRAFs 22. For example, the predefined constraint comprises a minimum distance between target features 14 and/or SRAFs 22, preferably a minimum distance below 60 nm, more preferably below 50 nm, most preferably below 40 nm. Target features 14 and SRAFs 22 having a distance below the minimum distance can, thus, be assigned to one or more critical locations 24. In this way, target features 14 and SRAFs 22 that are very close to each other and potentially interfere during printing form one or more critical locations 24, which are further analyzed with respect to the aerial image 44 of these critical locations 24. Alternatively, target features 14 or SRAFs 22 having a distance above the minimum distance to all other target features 14 or SRAFs 22 can be assigned to one or more critical locations 24. In this way, isolated target features 14 and SRAFs 22 are assigned to a critical location 24, which is further analyzed with respect to the aerial image 44.

According to an example of the first embodiment of the invention, the predefined constraint comprises an area constraint defining a minimum area of target features 14 and SRAFs 22. In this way, target features 14 and SRAFs 22 of small area, which could accidentally be removed during printing, are assigned to one or more critical locations 24.

According to an example of the first embodiment of the invention, the predefined constraint comprises a size constraint defining a minimum size of one or more dimensions of target features 14 and SRAFs 22. In this way, for example, design rules referring to feature sizes can be verified and compliance can be checked. For example, a design rule indicating a minimum feature size in one or more dimensions, e.g., 30 nm, can be checked.

According to an example of the first embodiment of the invention, the predefined constraint comprises predefined shapes of target features 14 and/or SRAFs 22. In this way, target features 14 and/or SRAFs 22 of a specific shape, which are known to the fab to cause defects 28 can be assigned to one or more critical locations 24. For example, L-shaped features or T-shaped features can be assigned to one or more critical locations 24.

According to an example of the first embodiment of the invention, the predefined constraint comprises a predefined pattern of target features 14 and/or SRAFs 22. In this way, specific patterns known to cause defects 28, e.g., logical patterns, form one or more critical locations 24.

According to an example of the first embodiment of the invention, the predefined constraint comprises a predefined location of target features 14 and/or SRAFs 22. In this way, for example, desired as well as undesired overlays of patterns can be verified. For example, the predefined location can comprise an alignment feature, which is used to align the photolithography mask 76 to a wafer. In this way, the correct printing of alignment features can be verified. In another example, the predefined location comprises a target feature 14, which overlaps with another target feature 14 in a layer above or below the layer associated with the photolithography mask 76. In this way, target features 14 connecting different layers of the semiconductor device can be assigned to one or more critical locations 24. The predefined location can also comprise a target feature 14 and another overlapping target feature 14, which together form a structure and, thus, must be connected, e.g., a T-structure containing two straight lines, which must overlap to create a connection. This situation can, for example, occur in case of multi patterning. In another example, undesired connections between target features 14 can be checked, e.g., a target feature 14 of a metal layer and another target feature 14 of a VIA layer above or below, which must not be connected.

According to an example of the first embodiment of the invention, each target feature 14 and each SRAF 22 is associated with a metric value and the predefined constraint is associated with a limit value, and a predefined number of critical locations 24 is selected from the identified one or more critical locations 24 according to the distance of the metric value of the corresponding target features 14 or SRAFs 22 to the limit value. For example, the target features 14 and SRAFs 22 corresponding to a critical location 24 are associated with a metric value such as size, distance, area etc., and the predefined constraint comprises a minimum or maximum value, and the critical locations 24 are sorted according to the distance of the corresponding metric value to the minimum or maximum value, and the first elements from the list are selected. For example, if the predefined constraint comprises a minimum feature size of 30nm, then all features below this feature size are identified as critical locations 24. Then the critical locations 24 are sorted according to increasing feature size, and the first N critical locations 24 are selected from this list. In this way, the most critical locations 24 among the critical locations 24 are selected for further analysis.

Optionally, common methods for etch and resist correction known to a person skilled in the art can be applied to the model 10 of the photolithography mask 76.

Fig. 3 illustrates the prediction of defects 28 based on a comparison of an aerial image 44 of the photolithography mask 76 to a reference image 46. To this end, the aerial image comprises predicted features 48, which are compared to the reference features 50 in the reference image 46. The comparison of the aerial image 44 to the reference image 46 can be carried out in various ways. For example, a difference image 51 of the aerial image 44 and the reference image 46 can be computed.

According to an example of the first embodiment of the invention, comparing the aerial image 44 to the reference image 46 comprises the computation of at least one distance measure, in particular at least one distance metric. For example, the pixel-wise sum of squared differences can be computed, which corresponds to the squared *L*₂-metric.

According to an example of the first embodiment of the invention, comparing the aerial image 44 to the reference image 46 comprises the application of a machine learning model. The machine learning model, e.g., a convolutional neural network, can be trained to predict defects 28 from input images comprising the aerial image 44 and/or the reference image 46 and/or the difference image 51. The machine learning model can, for example, be trained on a number of pairs of aerial images 44 and reference images 46 with indicated defects 28. Alternatively, the machine learning model can be trained on difference images 51. The defect prediction can be used as a distance measure.

There are different ways of generating a reference image 46.

According to an example of the first embodiment of the invention, the reference image 46 comprises a software simulation of an aerial image of the model of the photolithography mask 76 comprising one or more identified critical locations 24. The software simulates the photolithography process based on the model 10 of the photolithography mask 76. The simulated aerial image is compared to the acquired aerial image 44 and defects 28 are predicted based on the difference image 51.

According to an example of the first embodiment of the invention, the reference image 46 comprises an aerial image 44 of a photolithography mask 76 obtained from a database 86, the aerial image 44 comprising target features 14 substantially identical to the target features 14 in the one or more identified critical locations 24 of the photolithography mask 76. In this way, acquired aerial images 44 or software-based simulations of aerial images 44 comprising substantially identical target features 14 are used for the comparison. This way of comparing the aerial image 44 to a reference image 46 is a die-to-database method. The reference image 46 in the database 86 can, for example, comprise a simulation of the ideal target features 14 as modeled by the designer. Since the ideal target features 14 are known, each defect 28 can be predicted correctly during the comparison. In this way, the accuracy of the predicted defects 28 is improved. However, registration of the reference image 46 and the aerial image 44 is required.

According to an example of the first embodiment of the invention, the reference image 46 comprises an aerial image 44 of a second photolithography mask 76 comprising target features 14 substantially identical to the target features 14 in the one or more identified critical locations 24 of the photolithography mask 76. This way of comparing the aerial image 44 to a reference image 46 is a die-to-die method. In this way, the accuracy of the predicted defects 28 is improved. As there is no need for a model of the ideal target features 14, the effort for the applicant is reduced. However, defects 28 present in both photolithography masks 76 may not be predicted, and registration of the reference image 46 and the aerial image 44 is still required.

According to an example of the first embodiment of the invention, the reference image 46 comprises an acquired aerial image 44 or a simulated aerial image 44 of a different portion of the photolithography mask 76 comprising target features 14 substantially identical to the target features 14 in the one or more identified critical locations 24 of the photolithography mask 76. The simulated aerial image 44 can be generated by means of a software-based simulation. This way of comparing the aerial image 44 to a reference image 46 is an intra-die method. In this way, the accuracy of the predicted defects 28 is improved. As there is no need for a model of the ideal target features 14 nor for a second simulated or acquired aerial image, the effort for the applicant is even further reduced. However, repeater defects occurring in various locations of the photolithography mask 76 may not be predicted, and registration of the different portions of the photolithography mask 76 is still required.

According to an example of the first embodiment of the invention, the reference image 46 is generated by a machine learning model, in particular by an autoencoder, that maps the aerial image 44 to a substantially defect-free aerial image. The machine learning model can be trained to generate the reference image 46 from the aerial image 44 based on training data comprising substantially defect-free aerial images 44. Substantially defect-free here means that less than 5% of the pixels of each aerial image 44 are part of a defect 28. By comparing the aerial image 44 to the machine learning model generated reference image 46, defects 28 can be predicted. This way of comparing the aerial image 44 to a reference image 46 is a single-die method. In this way, the accuracy of the predicted defects 28 is improved. At the same time, the effort for the applicant for defect prediction is reduced most, as no reference image 46 needs to be provided, nor is registration necessary.

The machine learning model can comprise an autoencoder. An autoencoder is a type of artificial neural network used in unsupervised learning to learn efficient codings of unlabeled data. An autoencoder comprises two main parts: an encoder that maps the input into a code, and a decoder that maps the code to a reconstruction of the input. The input of the autoencoder can, for example, comprise an aerial image 44 or a subset thereof. The encoder neural network and the decoder neural network can be trained to minimize a difference between the reconstructed representation of the input and the input itself. The code typically is a representation of the input with lower dimensionality and can, thus, be viewed as a compressed version of the input. For this reason, autoencoders are forced to reconstruct the input approximately, preserving only the most relevant aspects of the input in the reconstruction.

Therefore, autoencoders can be used for the prediction of defects 28. Defects 28 generally concern rare deviations from the norm within an aerial image 44. Due to the rarity of their occurrence the autoencoder will not reconstruct this kind of information, thus suppressing defects 28 in the reconstruction. Defects 28 can then be predicted by comparing the imperfect reconstruction of the aerial image 44 to the aerial image 44. The larger the difference between them, the more likely a defect 28 is present.

Instead of applying the autoencoder to the full aerial image 44, the aerial image 44 can be subdivided into smaller subsets. The autoencoder can then be applied to each of the subsets separately. In this way, the required complexity of the autoencoder is reduced due to the reduced size of the input, thus improving the accuracy of the reconstruction and the defect detection.

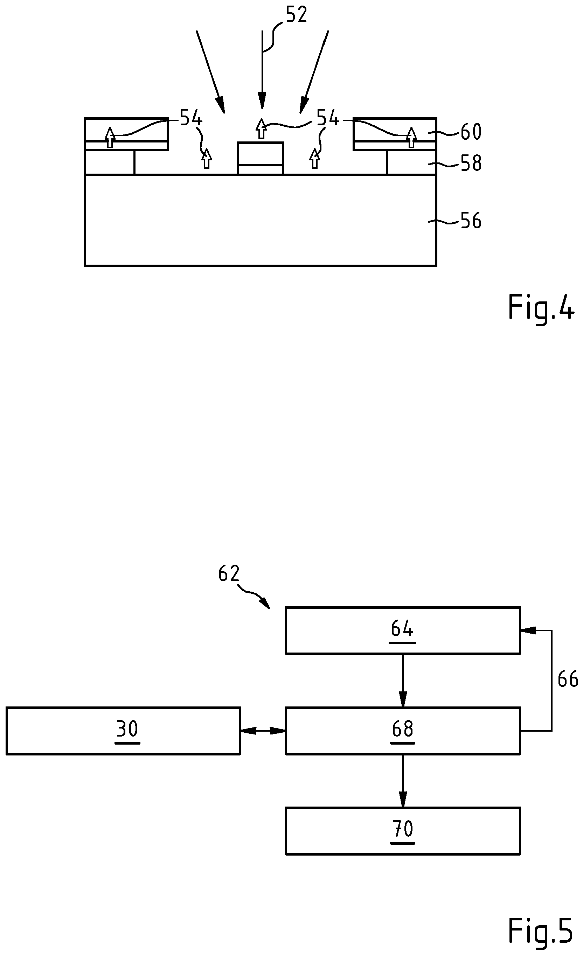

According to an example of the first embodiment of the invention, the photolithography mask 76 is associated with a layer of a semiconductor design, and the aerial image 44 simulates back-scattering 54 of light from printed layers below the layer associated with the photolithography mask 76. Fig. 4 illustrates the simulation of back-scattering 54 during aerial image generation. Incoming light 52 due to the application of photolithography mask n+1 is reflected by the previously printed layers, that is from the first layer 56, the second layer 58 and all layers up to the n-th layer 60.

Commonly, defect detection methods in wafers analyze short loop wafers, i.e., only single layers of a wafer without taking into account light reflected from the layers below. Therefore, by simulating back-scattering 54 from layers below the layer associated with the photolithography mask 76 the aerial image 44 allows for a more accurate simulation of the printed semiconductor structures on the wafer and, therefore, allows for a more accurate prediction of defects 28.

Traditionally, process window definition forms one of the most important steps of high-volume manufacturing. It takes about two weeks to qualify a process window for a particular part. Due to the ever-shrinking integrated circuit structures, this process has become more chip specific. Even within a technology node, multiple qualifications for multiple chips need to be done. Currently there is no way to predict the process window at a theoretical or simulation level. Thus, fabs have to spare tools, time and resources for this exploratory work. Therefore, a wafer-less process window qualification method is desirable. Such a method can be obtained based on the method for inspecting a photolithography mask 76 to predict defects 28 in wafers according to the first embodiment of the invention.

Fig. 5 shows a flowchart of a method 62 for wafer-less process window qualification for a photolithography mask 76 and a photolithography system according to a second embodiment of the invention, the method comprising an iteration 66 of the following steps: for at least one photolithography process parameter of the photolithography system selecting a photolithography process parameter value from a predefined range of photolithography process parameter values in a parameter selection step 64, and, in a defect prediction step 68, inspecting the photolithography mask 76 to predict defects 28 in wafers using any of the methods 30 for inspecting a photolithography mask 76 to predict defects 28 in wafers described above, wherein the aerial image 44 of the photolithography mask 76 is acquired using an aerial image measurement system 74 and a model of the photolithography system comprising the at least one selected photolithography process parameter value. After the final iteration, a process window for the at least one photolithography process parameter is determined by analyzing the predicted defects 28 for different photolithography process parameter values in a process window qualification step 70. Based on the qualified process window, parameter values for the parameters of the photolithography process can be selected and applied during high volume manufacturing of semiconductor devices.

Due to the simulation of the photolithography process for the photolithography mask 76 and the photolithography system by acquiring the aerial image 44, an actual printing of wafers is not required for process window qualification. Thus, the process window qualification can be carried out offline. Therefore, the fabs save a lot of time, tools and resources.

The above-described wafer-less process window qualification method according to the second embodiment of the invention has several advantages: firstly, the process window qualification method is based on an aerial image 44 generated from the photolithography mask 76 itself instead of a mere model 10 of the photolithography mask 76. Thus, error sources such as mask imperfections and registration errors are taken into account leading to defect predictions of improved accuracy. Secondly, random process defects during wafer printing mostly resulting from nuisances, which are not detrimental to the functioning of the semiconductor device, do not influence the process window qualification. Thirdly, the aerial image 44 takes into account intensity models of the layers below the layer associated with the photolithography mask 76 and, thus, predicts defects 28 with an improved accuracy. Fourthly, stochastic effects of the scanner, which pose a common problem during wafer-based process window qualification, do not influence the wafer-less process window qualification.

The wafer-less process window qualification can be a substitute for wafer-based process window qualification, or it can be used as a reference process for subsequent processes.

According to a third embodiment of the invention, a computer-readable medium is disclosed, having stored thereon a computer program executable by a computing device, the computer program comprising code for executing any of the methods described above.

According to a fourth embodiment of the invention, a computer program product is disclosed comprising instructions which, when the program is executed by a computer, cause the computer to carry out any of the methods described above.

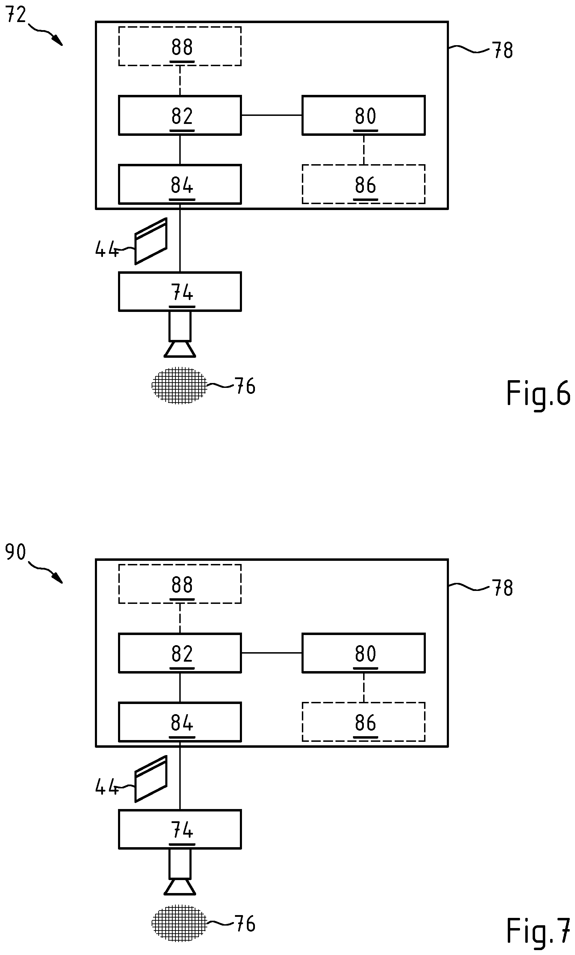

Fig. 6 illustrates a photolithography mask inspection system 72 for the prediction of defects 28 according to a fifth embodiment of the invention, the system comprising: a aerial image measurement system 74 for acquiring an aerial image 44 of the photolithography mask 76, and a data analysis device 78 comprising at least one memory 80 and at least one processor 82 configured to perform the steps of a method 30 according to any of the methods for inspecting a photolithography mask 76 to predict defects 28 in wafers described above. The aerial image 44 is transferred to the data analysis device 78 via an interface 84. The photolithography mask inspection system 72 can comprise a database 86 and/or a user interface 88.

The aerial image measurement system 74 can provide an aerial image 44 to the data analysis device 78. The data analysis device 78 includes a processor 82, e.g., implemented as a CPU or GPU. The processor 82 can receive the aerial image 44 via an interface 84. The processor 82 can load program code from a memory 80. The processor 82 can execute the program code. Upon executing the program code, the processor 82 performs techniques such as described herein, e.g., inspecting a photolithography mask 76 to predict defects 28 in wafers, computing an aerial image 44, a reference image 46 or a difference image 51, evaluating a predefined constraint, etc. For example, the processor 82 can perform any of the above-described examples of the method 30 shown in Fig. 2 upon loading program code from the memory 80.

Fig. 7 illustrates a wafer-less process window qualification system 90 comprising an aerial image measurement system 74 for acquiring an aerial image 44 of the photolithography mask 76 and a data analysis device 78 comprising at least one memory 80 and at least one processor 82 configured to perform the steps of the method 62 for wafer-less process window qualification for a photolithography mask 76 and a photolithography system as described above. The aerial image 44 is transferred to the data analysis device 78 via an interface 84. The photolithography mask inspection system 72 can comprise a database 86 and/or a user interface 88.

The aerial image measurement system 74 can provide an aerial image 44 to the data analysis device 78. The data analysis device 78 includes a processor 82, e.g., implemented as a CPU or GPU. The processor 82 can receive the aerial image 44 via an interface 84. The processor 82 can load program code from a memory 80. The processor 82 can execute the program code. Upon executing the program code, the processor 82 performs techniques such as described herein, e.g., wafer-less process window qualification for a photolithography mask 76 and a photolithography system. For example, the processor 82 can perform any of the above-described examples of the method 62 shown in Fig. 5 upon loading program code from the memory 80.

Reference throughout this specification to "an embodiment" or "an example" or "an aspect" means that a particular feature, structure or characteristic described in connection with the embodiment, example or aspect is included in at least one embodiment, example or aspect. Thus, appearances of the phrases "according to an embodiment", "according to an example" or "according to an aspect" in various places throughout this specification are not necessarily all referring to the same embodiment, example or aspect, but may. Furthermore, the particular features or characteristics may be combined in any suitable manner, as would be apparent to one of ordinary skill in the art from this disclosure, in one or more embodiments.

Furthermore, while some embodiments, examples or aspects described herein include some but not other features included in other embodiments, examples or aspects combinations of features of different embodiments, examples or aspects are meant to be within the scope of the claims, and form different embodiments, as would be understood by those skilled in the art.

In summary, the invention relates to a method 30 for inspecting a photolithography mask 76 to predict defects 28 in wafers comprising: providing a model 10 of the photolithography mask 76 comprising one or more target features 14 and one or more sub-resolution assist features 22; identifying one or more critical locations 24 in the model 10 of the photolithography mask 76 by verifying a predefined constraint concerning the target features 14 and the sub-resolution assist features 22; acquiring an aerial image 44 of the photolithography mask 76 24 using an aerial image measurement system 74 and a model of a photolithography system; and predicting defects 28 in wafers by comparing the one or more identified critical locations 24 in the aerial image 44 to one or more corresponding locations in a reference image 46.

### Reference number list

- 10: Model
- 12: Target pattern
- 14: Target feature
- 16: Printed pattern
- 18: Printed feature
- 20: Corrected pattern
- 22: Sub-resolution assist feature
- 24: Critical location
- 26: Printed corrected pattern
- 28: Defect
- 30: Method
- 32: Model providing step
- 34: Critical location identification step
- 36: Aerial image acquisition step
- 38: Defect prediction step
- 40: Model modification step
- 42: Repair step
- 43: Process step
- 44: Aerial image
- 46: Reference image
- 48: Predicted feature
- 50: Reference feature
- 51: Difference image
- 52: Light
- 54: Back-scattering
- 56: First layer
- 58: Second layer
- 60: n-th layer
- 62: Method
- 64: Parameter selection step
- 66: Iteration
- 68: Defect prediction step
- 70: Process window determination step
- 72: Photolithography mask inspection system
- 74: Aerial image measurement system
- 76: Photolithography mask
- 78: Data analysis device
- 80: Memory
- 82: Processor
- 84: Interface
- 86: Database
- 88: User interface
- 90: Wafer-less process window qualification system

## Claims

1. A method (30) for inspecting a photolithography mask (76) to predict defects (28) in wafers, the method comprising:
- Providing a model (10) of the photolithography mask (76) comprising one or more target features (14) and one or more sub-resolution assist features (22), the photolithography mask (76) being configured for printing of the one or more target features (14) onto a wafer in a printing process using a photolithography system;
- Identifying one or more critical locations (24) in the model (10) of the photolithography mask (76) by verifying a predefined constraint concerning the target features (14) and the sub-resolution assist features (22);
- Acquiring an aerial image (44) of the photolithography mask (76) comprising one or more identified critical locations (24) using an aerial image measurement system (74) and a model of the photolithography system;
- Predicting defects (28) in wafers by comparing the one or more identified critical locations (24) in the aerial image (44) to one or more corresponding locations in a reference image (46).

2. The method according to claim 1, wherein the predicted defects (28) comprise sub-resolution assist feature related defects.

3. The method according to any one of the preceding claims, wherein the predefined constraint comprises a space constraint between target features (14) and/or sub-resolution assist features (22).

4. The method according to any one of the preceding claims, wherein the space constraint comprises a minimum distance between target features (14) and/or sub-resolution assist features (22), preferably a minimum distance below 60 nm, more preferably below 50 nm, most preferably below 40 nm.

5. The method according to any one of the preceding claims, wherein the predefined constraint comprises an area constraint defining a minimum area of target features (14) and/or sub-resolution assist features (22).

6. The method according to any one of the preceding claims, wherein the predefined constraint comprises a size constraint defining a minimum size of one or more dimensions of target features (14) and/or sub-resolution assist features (22).

7. The method according to any one of the preceding claims, wherein the predefined constraint comprises a predefined shape of target features (14) and/or sub-resolution assist features (22).

8. The method according to any one of the preceding claims, wherein the predefined constraint comprises a predefined pattern of target features (14) and/or sub-resolution assist features (22).

9. The method according to any one of the preceding claims, wherein the predefined constraint comprises a predefined location of target features (14) and/or sub-resolution assist features (22).

10. The method according to claim 9, wherein the predefined location comprises an alignment feature, which is used to align the photolithography mask (76) to a wafer.

11. Method according to claim 9, wherein the photolithography mask (76) is associated with a layer of a semiconductor design, and the predefined location comprises a target feature (14), which overlaps with another target feature (14) in a layer above or below the layer associated with the photolithography mask (76).

12. The method according to any one of the preceding claims, wherein each target feature (14) and each sub-resolution assist feature (22) is associated with a metric value and the predefined constraint is associated with a limit value, and wherein a predefined number of critical locations (24) is selected from the identified one or more critical locations (24) according to the distance of the metric value of the corresponding target feature (14) or sub-resolution assist feature (22) to the limit value.

13. The method of any one of the preceding claims, wherein the photolithography mask (76) is associated with a layer of a semiconductor design, and the aerial image (44) is acquired using aerial image intensity models of layers below the layer associated with the photolithography mask (76) that are provided by the aerial image measurement system.

14. The method according to any one of the preceding claims, wherein the photolithography mask (76) is associated with a layer of a semiconductor design, and the aerial image (44) simulates back-scattering (54) of light (52) from layers below the layer associated with the photolithography mask (76).

15. The method according to any one of the preceding claims, wherein the reference image (46) comprises a software simulation of an aerial image (44) of the model (10) of the photolithography mask (76) comprising one or more identified critical locations (24).

16. The method according to any one of the preceding claims, wherein the reference image (46) is generated by a machine learning model that maps the aerial image (44) to a substantially defect-free aerial image.

17. The method according to any one of the preceding claims, wherein comparing the aerial image (44) to the reference image (46) comprises the application of a machine learning model.

18. The method according to any one of the preceding claims, further comprising using the predicted defects (28) to modify the model (10) of the photolithography mask (76), in particular the sub-resolution assist features (22) of the model (10) of the photolithography mask (76).

19. The method according to any one of the preceding claims, further comprising using the predicted defects (28) to repair the photolithography mask (76).

20. A method (62) for wafer-less process window qualification for a photolithography mask (76) and a photolithography system comprising:
- Iterating the following steps:
• For at least one photolithography process parameter of the photolithography system selecting a photolithography process parameter value from a predefined range of photolithography process parameter values;
• Inspecting the photolithography mask (76) to predict defects (28) in wafers using the method (30) for inspecting a photolithography mask (76) to predict defects (28) in wafers according to any one of claims 1 to 16, wherein the aerial image (44) of the photolithography mask (76) is acquired using the aerial image measurement system and a model of the photolithography system comprising the at least one selected photolithography process parameter value;
- Providing a process window for the at least one photolithography process parameter by analyzing the predicted defects (28) for different photolithography process parameter values.

21. A photolithography mask inspection system (72) for the prediction of defects (28), the system comprising:
- an aerial image measurement system (74) for acquiring an aerial image (44) of the photolithography mask (76);
- a data analysis device (78) comprising at least one memory (80) and at least one processor (82) configured to perform the steps of a method (30) according to any one of claims 1 to 19.

22. A wafer-less process window qualification system (90) comprising:
- an aerial image measurement system (74) for acquiring an aerial image (44) of a photolithography mask (76);
- a data analysis device (78) comprising at least one memory (80) and at least one processor (82) configured to perform the steps of a method (30) according to claim 20.
